# FASCICULE DE BREVET EUROPEEN

(11) **EP 0 718 968 B1**
(45) Date de publication et mention de la délivrance du brevet: **19.04.2000**
(21) Numéro de dépôt: 95410144.0
(22) Date de dépôt: 18.12.1995
(51) Int. Cl.: H03F 3/45

(54) **Amplificateur à grande excursion de mode commun et à transconductance constante**
Verstärker mit grossem Gleichtaktpegel und konstanter Transkonduktanz
Amplifier having common mode large swing and constant transconductance

(30) Priorité: 21.12.1994 FR 9415672
(43) Date de publication de la demande: 26.06.1996
(73) Titulaire: STMicroelectronics S.A., 94250 Gentilly (FR)
(72) Inventeur: Goutti, Frédéric, F-38000 Grenoble (FR)
(74) Mandataire: de Beaumont, Michel

(56) Documents cités:
- EP-A- 0 108 428
- US-A- 4 918 398
- IEEE JOURNAL OF SOLID STATE CIRCUITS, vol. 24, no. 6, - Décembre 1989 pages 1551-1559, FONDERIE ET AL. '1-v Operational Amplifier with Rail to Rail Input and Output Ranges'

## Description

La présente invention concerne un amplificateur à grande excursion de mode commun, c'est-à-dire dont les entrées peuvent être portées à des potentiels pratiquement égaux aux potentiels d'alimentation extrêmes de l'amplificateur, et dont la transconductance est constante sur toute la plage des tensions d'entrée. La présente invention vise plus particulièrement un tel amplificateur ayant un étage intermédiaire à cascode replié.

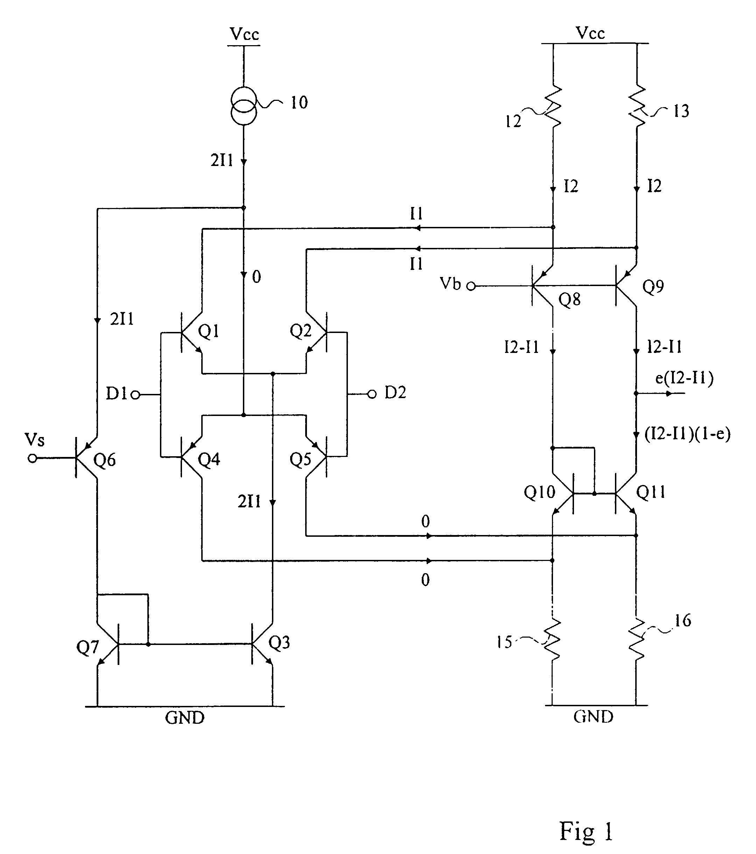

La figure 1 représente un exemple d'amplificateur ayant toutes ces caractéristiques, tel que décrit dans IEEE Journal of Solid-State Circuits, vol. 24, No. 6, décembre 1989, "1-V Operational Amplifier with Rail-to-Rail Input and Output Ranges". Il comprend deux étages différentiels d'entrée complémentaires. Le premier étage différentiel comprend deux transistors NPN Q1 et Q2 dont les émetteurs sont reliés à un potentiel d'alimentation bas GND par un transistor NPN Q3 formant un transistor de sortie d'un miroir de courant. Le deuxième étage différentiel comprend deux transistors PNP Q4 et Q5 dont les émetteurs sont reliés à un potentiel d'alimentation haut Vcc par l'intermédiaire d'une source de courant 10 fournissant un courant constant 2I1. Les bases des transistors Q1 et Q4 constituent une première entrée D1 de l'amplificateur, et les bases des transistors Q2 et Q5 constituent une deuxième entrée D2 de l'amplificateur.

La source de courant 10 est également reliée au potentiel GND par l'intermédiaire successivement d'un transistor de commutation PNP Q6 et d'un transistor NPN Q7 formant le transistor d'entrée du miroir de courant ayant le transistor Q3 comme transistor de sortie. Les émetteurs des transistors Q3 et Q7 sont reliés au potentiel GND et les bases des transistors Q3 et Q7 sont reliées au collecteur du transistor Q7. Le transistor Q6 a son émetteur relié à la source de courant 10, son collecteur relié au collecteur du transistor Q7, et sa base reliée à une tension de commutation constante Vs.

L'amplificateur de la figure 1 a deux plages principales de fonctionnement. Dans une première plage, pour laquelle on a représenté les valeurs de courant dans la figure 1, la tension de mode commun d'entrée de l'amplificateur (la moyenne des tensions sur les entrées D1 et D2) est supérieure à la tension Vs. Le transistor Q6 est alors passant et dérive la totalité du courant 2I1 de la source 10 vers le transistor Q7. Ce courant 2I1 est recopié par le transistor Q3 dans l'étage différentiel Q1, Q2, ce qui établit le courant de repos de chaque branche de sortie de cet étage (les collecteurs des transistors Q1 et Q2) à la valeur I1. L'étage Q1, Q2 est actif. Par contre, l'étage Q4, Q5 ne reçoit aucun courant de la source 10 ; il est inactif.

Dans la deuxième plage, la tension de mode commun d'entrée est inférieure à la tension Vs. Le transistor Q6 se bloque et la totalité du courant de la source 10 est fournie à l'étage Q4, Q5 dont chaque branche de sortie s'établit à un courant I1. Par contre, l'étage Q1, Q2 ne reçoit aucun courant. L'étage Q4, Q5 est actif et l'étage Q1, Q2 inactif.

Avec cette configuration, un seul étage à la fois est actif, quelle que soit la tension de mode commun d'entrée. Ceci permet d'assurer que la transconductance de l'amplificateur est toujours égale à celle d'un seul étage, c'est-à-dire qu'elle est constante.

En pratique, les deux étages sont partiellement actifs dans une plage transitoire où la tension de mode commun d'entrée est voisine de la tension Vs. La constance de la transconductance n'est pas affectée par cette plage transitoire.

L'amplificateur de la figure 1 comprend un étage intermédiaire à cascode replié. On peut être tenté d'utiliser un tel étage car il présente l'avantage d'améliorer la rapidité et la stabilité de l'amplificateur par rapport à d'autres types d'étage de sortie. Cet étage à cascode replié comprend deux transistors cascode PNP Q8 et Q9 dont les bases sont polarisées par une même tension de référence Vb. Les émetteurs des transistors Q8 et Q9 sont reliés au potentiel Vcc par des résistances respectives 12 et 13 de même valeur, et sont également reliés respectivement aux collecteurs des transistors Q1 et Q2 (branches de sortie de l'étage Q1, Q2). Les collecteurs des transistors Q8 et Q9 sont reliés respectivement aux collecteurs de deux transistors NPN Q10 et Q11. Les transistors Q10 et Q11 sont respectivement un transistor d'entrée et un transistor de sortie d'un miroir de courant. Les bases des transistors Q10 et Q11 sont reliées au collecteur du transistor Q10 et les émetteurs de ces transistors sont reliés au potentiel GND par des résistances respectives 15 et 16 de même valeur. La sortie de l'amplificateur est prélevée sur les collecteurs des transistors Q9 et Q11. Les émetteurs des transistors Q10 et Q11 sont également reliés respectivement aux collecteurs des transistors Q4 et Q5 (branches de sortie de l'étage différentiel Q4, Q5).

L'utilisation d'un étage de sortie à cascode replié dans un amplificateur à deux étages différentiels d'entrée complémentaires commutés, du type de la figure 1, présente l'inconvénient de détériorer la caractéristique de réjection de mode commun de l'amplificateur. Comme dans tout amplificateur imparfait, le signal de sortie de l'amplificateur de la figure 1 varie en fonction de la tension de mode commun d'entrée. Cette variation reste relativement faible dans chacune des plages de fonctionnement de l'amplificateur. Toutefois, au moment de la commutation d'une plage à l'autre, le signal de sortie présente un saut qui est à l'origine de la dégradation de la réjection de mode commun.

Un objet de la présente invention est de réaliser un amplificateur du type de la figure 1 muni d'un circuit de compensation pour supprimer le saut présenté par le signal de sortie lorsque l'amplificateur passe d'une plage de fonctionnement à l'autre.

Ces objets sont atteints grâce à un amplificateur comprenant deux étages différentiels d'entrée complémentaires ; une première source de courant commutée en fonction de la tension d'entrée de l'amplificateur pour rendre actif l'un ou l'autre des étages d'entrée en établissant son courant de repos ; et un étage à cascode replié ayant deux transistors cascode dont les courants sont déterminés par une tension de polarisation de ces transistors et diminués par les courants circulant dans les branches de sortie d'un premier des étages différentiels d'entrée. L'amplificateur comprend des moyens commutés en même temps que la première source de courant pour maintenir constant le courant dans les transistors cascode lorsque l'un des étages différentiels passe entre un état actif et un état inactif.

Selon un mode de réalisation de la présente invention, un maintien à une valeur constante du courant des transistors cascode est assuré en modifiant la tension de polarisation de ces transistors cascode.

Selon un mode de réalisation de la présente invention, les transistors cascode reliés à un potentiel d'alimentation par des premières résistances respectives de même valeur, et forment des transistors de sortie d'un premier miroir de courant. Les branches de sortie du premier étage différentiel sont reliées entre les transistors cascode et les premières résistances. Un transistor d'entrée du premier miroir de courant est relié audit potentiel d'alimentation par une deuxième résistance de même valeur que les premières, et reçoit un courant constant. Une deuxième source de courant est commutée pour injecter entre la deuxième résistance et le transistor d'entrée du premier miroir, lorsque le premier étage différentiel est actif, un courant égal au courant de repos de chaque branche de sortie du premier étage différentiel.

Selon un mode de réalisation de la présente invention, la deuxième source de courant est une première sortie d'un deuxième miroir de courant dont une deuxième sortie établit le courant de repos du premier étage différentiel, et dont l'entrée est reliée à la première source de courant par un transistor de commutation en fonction de la tension d'entrée de l'amplificateur. La première source de courant est également reliée au deuxième étage différentiel d'entrée pour établir le courant de repos de ce deuxième étage différentiel.

Ces objets, caractéristiques, avantages ainsi que d'autres de la présente invention seront exposés plus en détail dans la description suivante de modes de réalisation particuliers, faite à titre non-limitatif à l'aide des figures jointes parmi lesquelles :
la figure 1 représente un exemple d'amplificateur à transconductance constante sur une grande plage d'excursion de mode commun, muni d'un étage de sortie à cascode replié ; et
la figure 2 représente un amplificateur du type de la figure 1 muni d'un mode de réalisation de circuit selon l'invention pour améliorer la réjection de mode commun de l'amplificateur.

La présente invention est basée sur l'analyse suivante du fonctionnement de l'amplificateur de la figure 1. La tension d'émetteur des transistors Q8 et Q9 est fixée à une valeur constante par la tension de polarisation Vb. Ainsi, le courant dans chacune des résistances 12 et 13 est fixé à une valeur constante I2 que l'on choisit supérieure à la valeur I1 du courant de repos dans chacune des branches de l'étage différentiel Q1, Q2.

Lorsque l'étage différentiel Q1, Q2 est actif, ses branches prélèvent chacune un courant de repos I1 sur les émetteurs des transistors Q8 et Q9. Ainsi, les courants des transistors Q8 et Q9 s'établissent à la valeur I2-I1. L'étage Q4, Q5 étant inactif, ses branches de sortie n'injectent aucun courant sur les émetteurs des transistors Q10 et Q11. Les transistors Q10 et Q11 se comportent en miroir de courant et le courant du transistor Q10 est recopié dans le collecteur du transistor Q11. Toutefois, cette recopie n'est pas parfaite, car le courant I2-I1 arrivant sur le transistor Q10 est recopié avec un coefficient de proportionnalité 1-e légèrement inférieur à 1, quelle que soit la qualité du miroir de courant employé. Par conséquent, le courant de sortie de l'amplificateur présente un décalage de e(I2-I1) par rapport à la valeur souhaitée.

Lorsque l'étage Q4, Q5 est actif, ses branches injectent chacune un courant I1 sur les émetteurs des transistors Q10 et Q11. Les branches de sortie de l'étage différentiel Q1, Q2 ne soutirent plus de courant sur les émetteurs des transistors Q8 et Q9 qui sont alors traversés chacun par un courant I2. Ce courant I2, arrivant sur le collecteur du transistor Q10, est recopié sur le collecteur du transistor Q11 avec le coefficient de proportionnalité 1-e susmentionné. La sortie de l'amplificateur fournit alors un courant de décalage de valeur eI2 au lieu de e(I2-I1).

Par conséquent, en passant d'une plage de fonctionnement à l'autre, le courant de décalage en sortie de l'amplificateur présente un saut de valeur eI1 qui est loin d'être négligeable et dégrade considérablement la réjection de mode commun de l'amplificateur.

Ce saut, comme le montre la précédente analyse, est dû au fait que le courant des transistors Q8 et Q9 passe d'une valeur I2-I1 à une valeur I2 lorsque l'on passe d'une plage de fonctionnement à l'autre. Pour éviter le saut du courant de sortie, la présente invention propose de maintenir constant le courant des transistors Q8 et Q9 sur l'ensemble des plages de fonctionnement de l'amplificateur.

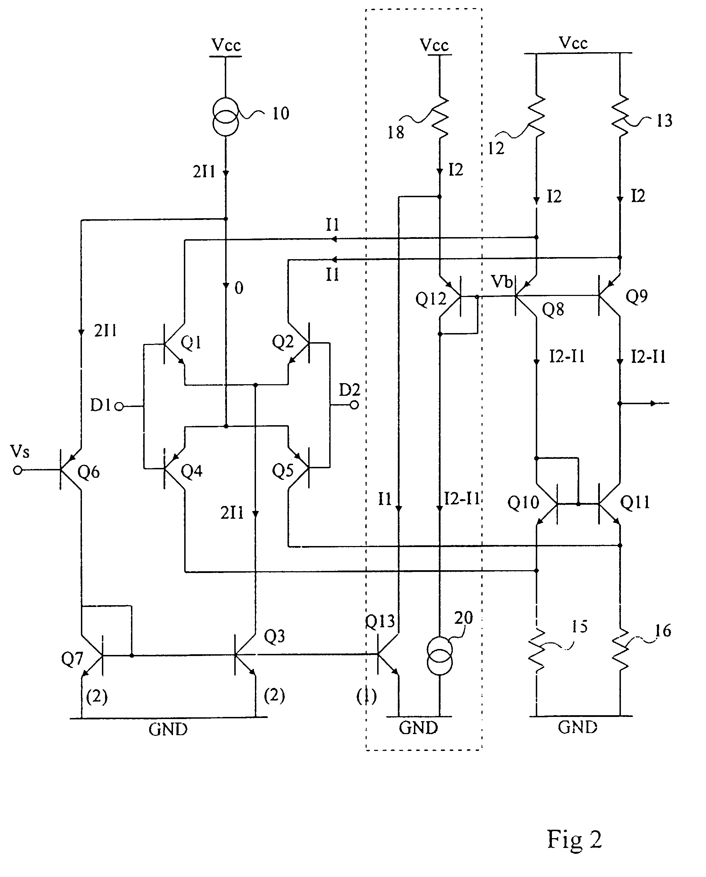

La figure 2 représente l'amplificateur de la figure 1 muni d'un mode de réalisation de circuit selon l'invention permettant d'obtenir cette constance de courant dans les transistors Q8 et Q9. Ce circuit est représenté dans un cadre en pointillés.

Les transistors Q8 et Q9, plutôt que d'être polarisés par une tension constante Vb, constituent deux transistors de sortie d'un miroir de courant dont le transistor d'entrée est un transistor PNP Q12. Le transistor Q12 a sa base reliée à son collecteur et aux bases des transistors Q8 et Q9. L'émetteur du transistor Q12 est relié au potentiel Vcc par une résistance 18 de même valeur que les résistances 12 et 13. Le collecteur du transistor Q12 est relié au potentiel GND par une source de courant 20 de valeur constante I2-I1. Un transistor NPN Q13 constitue un deuxième transistor de sortie du miroir de courant Q3, Q7 et est relié en parallèle par sa base et son émetteur sur le transistor Q3. Le collecteur du transistor Q13 est relié à l'émetteur du transistor Q12. Comme cela est indiqué sur la figure 2 entre parenthèses, la taille des transistors Q3 et Q7 est deux fois supérieure à celle du transistor Q13. Ainsi, le courant de collecteur du transistor Q13 est la moitié de celui du transistor Q3.

Dans la première plage de fonctionnement de l'amplificateur, pour laquelle les valeurs des courants sont indiquées sur la figure 2, la totalité du courant 2I1 de la source 10 est fournie à l'étage différentiel Q1, Q2 par le transistor Q3, et la moitié de ce courant, I1, est prélevée sur l'émetteur du transistor Q12 par le transistor Q13. Ainsi, un courant Il est prélevé sur chacun des émetteurs des transistors Q8, Q9 et Q12. Les transistors Q8, Q9 et Q12 se trouvent alors dans les mêmes conditions de fonctionnement et se comportent en miroir de courant ; le courant de collecteur I2-I1 du transistor Q12 est recopié dans les collecteurs des transistors Q8 et Q9.

Dans la deuxième plage de fonctionnement, la totalité du courant 2I1 de la source 10 est fournie à l'étage différentiel Q4, Q5. Aucun courant n'est alors prélevé sur les émetteurs des transistors Q8, Q9 et Q12 par les branches de l'étage différentiel Q1, Q2 et par le transistor Q13. Les transistors Q8, Q9 et Q12 se trouvent de nouveau dans les mêmes conditions de fonctionnement et se comportent en miroir de courant. Le courant de collecteur I2-I1 du transistor Q12 est toujours recopié dans les collecteurs des transistors Q8 et Q9.

Les courants de collecteur des transistors Q8 et Q9 ne varient pas d'une plage de fonctionnement à l'autre, ce qui supprime le saut subi par le signal de décalage en sortie de l'amplificateur.

La présente invention est susceptible de nombreuses variantes et modifications qui apparaîtront à l'homme du métier. Par exemple, si les transistors Q10 et Q11 sont des transistors cascode polarisés par une tension fixe, et si les transistors Q8 et Q9 forment un miroir de courant, le saut en sortie de l'amplificateur peut être supprimé en injectant dans les résistances 15 et 16 une recopie du courant de collecteur du transistor Q13.

## Revendications

1. Amplificateur comprenant :
- deux étages différentiels d'entrée complémentaires (Q1, Q2 ; Q4, Q5) ;
- une première source de courant (10) commutée en fonction de la tension d'entrée de l'amplificateur pour rendre actif l'un ou l'autre des étages d'entrée en établissant son courant de repos (2I1) ;
- un étage à cascode replié ayant deux transistors cascode (Q8, Q9) dont les courants (I2) sont déterminés par une tension de polarisation (Vb) de ces transistors et diminués par les courants (I1) circulant dans les branches de sortie d'un premier (Q1, Q2) des étages différentiels d'entrée ;
caractérisé en ce qu'il comprend des moyens (Q13, Q12) commutés en même temps que la première source de courant (10) pour maintenir constant le courant dans les transistors cascode lorsque l'un des étages différentiels passe entre un état actif et un état inactif.

2. Amplificateur selon la revendication 1, caractérisé en ce que lesdits moyens assurent un maintien à une valeur constante du courant des transistors cascode (Q8, Q9) en modifiant la tension de polarisation (Vb) de ces transistors cascode.

3. Amplificateur selon la revendication 2, caractérisé en ce qu'il comprend :
- les transistors cascode (Q8, Q9) reliés à un potentiel d'alimentation (Vcc) par des premières résistances respectives (12, 13) de même valeur, et formant des transistors de sortie d'un premier miroir de courant (Q12, Q8, Q9), les branches de sortie du premier étage différentiel (Q1, Q2) étant reliées entre les transistors cascode et les premières résistances ;
- un transistor d'entrée (Q12) du premier miroir de courant, relié audit potentiel d'alimentation par une deuxième résistance (18) de même valeur que les premières, recevant un courant constant (I2-I1) ; et
- une deuxième source de courant commutée (Q13) pour injecter entre la deuxième résistance (18) et le transistor d'entrée (Q12) du premier miroir, lorsque le premier étage différentiel est actif, un courant (I1) égal au courant de repos de chaque branche de sortie du premier étage différentiel.

4. Amplificateur selon la revendication 3, caractérisé en ce que la deuxième source de courant (Q13) est une première sortie d'un deuxième miroir de courant dont une deuxième sortie (Q3) établit le courant de repos du premier étage différentiel (Q1, Q2) et dont l'entrée (Q7) est reliée à la première source de courant (10) par un transistor (Q6) de commutation en fonction de la tension d'entrée de l'amplificateur, la première source de courant étant également reliée au deuxième étage différentiel d'entrée (Q4, Q5) pour établir le courant de repos de ce deuxième étage différentiel.

## Patentansprüche

1. Verstärker, umfassend:
- zwei komplementäre Differentialeingangsstufen (Q1, Q2; Q4, Q5);
- eine erste geschaltete Stromquelle (10), die als eine Funktion der Eingangsspannung des Verstärkers geschaltet wird, um die eine oder die andere der Differentialeingangsstufen unter Einstellung ihres Ruhestroms (2I1) zu aktivieren;
- eine gefaltete Kaskodenstufe mit zwei Kaskodentransistoren (Q8, Q9), deren Ströme (I2) durch eine Vorspannung (Vb) dieser Transistoren bestimmt und durch die in den Ausgangszweigen einer ersten der Differentialeingangsstufen (Q1, Q2) zirkulierenden Ströme (I1) verringert wird;
**gekennzeichnet** durch Mittel (Q13, Q12), die gleichzeitig wie die erste Stromquelle (10) geschaltet werden, um den Strom in den Kaskodentransistoren konstant zu halten, wenn eine der Differentialeingangsstufen zwischen einem aktiven Zustand und einem inaktiven Zustand wechselt.

2. Verstärker nach Anspruch 1, dadurch **gekennzeichnet,** daß die Mittel einen konstanten Strom in den Kaskodentransistoren (Q8, Q9) sicherstellen, indem sie die Vorspannung (Vb) dieser Kaskodentransistoren modifizieren.

3. Verstärker nach Anspruch 2, dadurch **gekennzeichnet,** daß er umfaßt:
- die Kaskodentransistoren (Q8, Q9), welche mit einer Versorgungsspannung (Vcc) über jeweils erste Widerstände (12, 13) mit gleichem Wert verbunden sind und Ausgangstransistoren eines ersten Stromspiegels (Q12, Q8, Q9) bilden, wobei die Ausgangszweige der ersten Differentialstufe (Q1, Q2) zwischen den Kaskodentransistoren und den ersten Widerständen angeschlossen sind;
- ein Eingangstransistor (Q12) des ersten Stromspiegels, der mit der Versorgungsspannung über einen zweiten Widerstand (18) mit gleichem Wert wie die ersten Widerstände verbunden ist und einen konstanten Strom (I2-I1) empfängt; und
- eine zweite geschaltete Stromquelle (Q13) zum Einspeisen eines Stroms (I1), der gleich dem Ruhestrom jedes Ausgangszweigs der ersten Differentialstufe ist, zwischen dem zweiten Widerstand (18) und dem Eingangstransistor (Q12) des ersten Stromspiegels, wenn die erste Differentialstufe aktiv ist.

4. Verstärker nach Anspruch 3, dadurch **gekennzeichnet,** daß die zweite Stromquelle (Q13) ein erster Ausgang eines zweiten Stromspiegels ist, der einen zweiten Ausgang (Q3) aufweist, der den Ruhestrom der ersten Differentialeingangsstufe (Q1, Q2) einstellt, und der einen Eingang (Q7) aufweist, der mit der ersten Stromquelle (10) über einen Transistor (Q6) verbunden ist, der als eine Funktion der Eingangsspannung des Verstärkers geschaltet wird, wobei die erste Stromquelle auch mit der zweiten Differentialeingangsstufe (Q4, Q5) verbunden ist, um den Ruhestrom dieser zweiten Differentialeingangsstufe einzustellen.

## Claims

1. An amplifier comprising:
- two complementary differential input stages (Q1, Q2; Q4, Q5);
- a first switched current source (10) that is switched as a function of the input voltage of the amplifier in order to render active one or the other of the differential input stages by establishing its quiescent current (2I1);
- a folded cascode stage having two cascode transistors (Q8, Q9) whose currents (I2) are determined by a bias voltage (Vb) of these transistors and reduced by the currents (I1) circulating in the output branches of a first of the differential input stages (Q1, Q2);
characterized in that it comprises means (Q13, Q12) switched at the same time as the first current source (10) for maintaining a constant current in the cascode transistors when one of the differential input stages changes between an active state and an inactive state.

2. An amplifier according to claim 1, characterized in that said means ensure a constant current in the cascode transistors (Q8, Q9) by modifying the bias voltage (Vb) of these cascode transistors.

3. An amplifier according to claim 2, characterized in that it comprises:
- said cascode transistors (Q8, Q9) connected to a supply voltage (Vcc) via first respective resistors (12, 13) of same value, and forming output transistors of a first current mirror (Q12, Q8, Q9), the output branches of the first differential stage (Q1, Q2) being connected between the cascode transistors and the first resistors;
- an input transistor (Q12) of the first current mirror, connected to said supply voltage by a second resistor (18) that has the same value as the first resistors, receiving a constant current (I2-I1); and
- a second switched current source (Q13) for injecting, between the second resistor (18) and the input transistor (Q12) of the first current mirror, when the first differential stage is active, a current (I1) equal to the quiescent current of each output branch of the first differential stage.

4. An amplifier according to claim 3, characterized in that the second current source (Q13) is a first output of a second current mirror having a second output (Q3) that establishes the quiescent current of the first differential input stage (Q1, Q2) and an input (Q7) connected to the first current source (10) by a transistor (Q6) that is switched as a function of the input voltage of the amplifier, the first current source also being connected to the second differential input stage (Q4, Q5) for establishing the quiescent current of this second differential input stage.
